# EUROPEAN PATENT APPLICATION

(11) **EP 4 665 112 A1**
(43) Date of publication of application: **17.12.2025**
(21) Application number: 24223537.2
(22) Date of filing: 27.12.2024
(51) Int. Cl.: H10D 84/01, H10D 30/01, H10D 30/63, H10D 84/85, H10D 84/83

(54) **CMOS INVERTER AND METHOD OF MANUFACTURING THE SAME**

(30) Priority: 13.06.2024 KR 20240077205
(71) Applicant: Korea Advanced Institute of Science and Technology, Daejeon 34141 (KR)
(72) Inventor: CHOI, Yang-Kyu, 34141 Daejeon (KR); YU, Jiman, 34141 Daejeon (KR)
(74) Representative: V.O.

(57) **Abstract**

A vertically upright CMOS inverter includes a base substrate, a p-type semiconductor layer, an n-type semiconductor layer, and a first gate electrode. The p-type semiconductor layer includes a first hole doping area, a second hole doping area, and a first channel area. The n-type semiconductor layer includes a first electron doping area, a second electron doping area, and a second channel area.

## Description

### CROSS-REFERENCE TO RELATED APPLICATIONS

This application claims priority under 35 U.S.C. § 119 to Korean Patent Application No. 10-2024-0077205 filed on June 13, 2024, in the Korean Intellectual Property Office, the disclosures of which are incorporated by reference herein in their entireties.

### BACKGROUND

Embodiments of the present disclosure described herein relate to a complementary metal-oxide semiconductor (CMOS) inverter and a method of manufacturing the same. More particularly, embodiments of the present disclosure described herein relate to a CMOS inverter including a complementary field effect transistor having a vertical upright channel structure and a method of manufacturing the same.

A CMOS inverter, which is a key component of a modern electronic device, serves to invert a logical state of a signal using two complementary transistors (N-channel metal oxide semiconductor (NMOS) and p-channel metal-oxide semiconductor (PMOS)). The CMOS inverter is used as an essential component in various digital circuits. With the development of a semiconductor element, various technologies for miniaturization and high integration of the CMOS inverter have been proposed.

However, miniaturization of a planar transistor is facing limitations. Further, there is a problem that a single-channel effect may occur due to side effects caused by excessive miniaturization. Accordingly, technology development for implementing the CMOS inverter that may achieve miniaturization and high integration is required.

### SUMMARY

Embodiments of the present disclosure provide a CMOS inverter capable of achieving high integration by applying a structure in which two transistors (NMOS and PMOS) are upright in a vertical direction, and a method of manufacturing the same.

Further, embodiments of the present disclosure also provide a CMOS inverter capable of achieving miniaturization because two transistors (NMOS and PMOS) share one gate electrode, and a method of manufacturing the same.

According to an embodiment, a CMOS inverter includes a base substrate, a p-type semiconductor layer, an n-type semiconductor layer, and a first gate electrode.

The base substrate may be parallel to a plane defined by a first direction and a second direction intersecting the first direction.

The p-type semiconductor layer may be disposed on the base substrate. The p-type semiconductor layer may include a first hole doping area, a second hole doping area, and a first channel area.

The n-type semiconductor layer may be disposed on the base substrate. The n-type semiconductor layer may be spaced apart from the p-type semiconductor layer. The n-type semiconductor layer may include a first electron doping area, a second electron doping area, and a second channel area.

The first gate electrode may be disposed on the base substrate. The first gate electrode may have a shape surrounding the first channel area and the second channel area.

The first hole doping area may be disposed adjacent to the base substrate.

The first channel area may be disposed adjacent to the first hole doping area in a third direction perpendicular to the first direction and the second direction.

The second hole doping area may be disposed adjacent to the first channel area in the third direction.

The first electron doping area may be disposed adjacent to the base substrate.

The second channel area may be disposed adjacent to the first electron doping area in the third direction.

The second electron doping area may be disposed adjacent to the second channel area in the third direction.

In an embodiment of the present disclosure, the CMOS inverter may further include a connection metal. The connection metal may be in contact with the first hole doping area and the first electron doping area.

In an embodiment of the present disclosure, the CMOS inverter may further include an insulating layer, a plurality of terminals, and a plurality of connection wiring lines.

The insulating layer may be disposed on the base substrate. The insulating layer may cover the p-type semiconductor layer, the n-type semiconductor layer, the connection metal, and the first gate electrode.

The plurality of terminals may be arranged on the insulating layer. The plurality of terminals may include a first input terminal, a power terminal, an output terminal, and a ground terminal.

The plurality of connection wiring lines may be arranged on the base substrate. The plurality of connection wiring lines may include a first connection wiring line, a second connection wiring line, a third connection wiring line, and a fourth connection wiring line.

The first connection wiring line may be in contact with the first input terminal and the first gate electrode.

The second connection wiring line may be in contact with the power terminal and the second hole doping area.

The third connection wiring line may be in contact with the output terminal and the connection metal.

The fourth connection wiring line may be in contact with the ground terminal and the second electron doping area.

In an embodiment of the present disclosure, a cross-sectional area of the p-type semiconductor layer may be greater than a cross-sectional area of the n-type semiconductor layer.

In an embodiment of the present disclosure, the CMOS inverter may further include a second gate electrode. The second gate electrode may be disposed on the base substrate. The second gate electrode may be spaced apart from the third connection wiring line.

The third connection wiring line may be disposed between the first channel area and the second channel area.

The second gate electrode may have a shape surrounding the third connection wiring line.

In an embodiment of the present disclosure, the plurality of terminals may further include a second input terminal.

The plurality of connection wiring lines may further include a fifth connection wiring line.

The fifth connection wiring line may be in contact with the second input terminal and the second gate electrode.

In an embodiment of the present disclosure, the first gate electrode may be in contact with the second gate electrode.

In an embodiment of the present disclosure, the CMOS inverter may further include a connection metal. The connection metal may be in contact with the second hole doping area and the second electron doping area.

In an embodiment of the present disclosure, the CMOS inverter may further include an insulating layer, a plurality of terminals, and a plurality of connection wiring lines.

The insulating layer may be disposed on the base substrate. The insulating layer may cover the p-type semiconductor layer, the n-type semiconductor layer, the connection metal, and the first gate electrode.

The plurality of terminals may be arranged on the insulating layer. The plurality of terminals may include a first input terminal, a power terminal, an output terminal, and a ground terminal.

The plurality of connection wiring lines may be arranged on the base substrate. The plurality of connection wiring lines may include a first connection wiring line, a second connection wiring line, a third connection wiring line, and a fourth connection wiring line.

The first connection wiring line may be in contact with the first input terminal and the first gate electrode.

The second connection wiring line may be in contact with the power terminal and the first hole doping area.

The third connection wiring line may be in contact with the output terminal and the connection metal.

The fourth connection wiring line may be in contact with the ground terminal and the first electron doping area.

According to an embodiment, a method of manufacturing a CMOS inverter includes a vertical semiconductor layer formation operation in which a first vertical semiconductor layer and a second vertical semiconductor layer are formed on a base substrate, an ion doping operation in which ions are doped to the first vertical semiconductor layer and the second vertical semiconductor layer, a gate formation operation in which a gate electrode is formed on the base substrate, a connection metal formation operation in which a connection metal in contact with the first vertical semiconductor layer and the second vertical semiconductor layer is formed on the base substrate, an insulating layer formation operation in which an insulating layer that covers the first vertical semiconductor layer, the second vertical semiconductor layer, the first gate electrode, and the connection metal is formed, and a wiring line connection operation in which the first vertical semiconductor layer, the second vertical semiconductor layer, the first gate electrode, and the connection metal are connected to a plurality of terminals arranged on the insulating layer.

The vertical semiconductor layer formation operation may include a sacrificial vertical column formation operation in which a sacrificial vertical column is formed on the base substrate, a spacer formation operation in which a spacer that covers a side surface of the sacrificial vertical column and an upper surface of the base substrate is formed, a spacer hard mask formation operation in which a portion of the spacer is etched to form a spacer hard mask surrounding the side surface of the sacrificial vertical column, a cutting operation in which the spacer hard mask and the sacrificial vertical column are cut in a direction perpendicular to the base substrate, a vertical layer formation operation in which a portion of the base substrate and the sacrificial vertical column are removed to form the first vertical semiconductor layer and the second vertical semiconductor layer, and a spacer hard mask removal operation in which the spacer hard mask is removed.

In an embodiment of the present disclosure, the ion doping operation may include a first hole doping area formation operation in which a first ion having first energy is doped in the direction perpendicular to the base substrate to form a first hole doping area, a second hole doping area formation operation in which a second ion having second energy different from the first energy is doped in the direction perpendicular to the base substrate to form a second hole doping area, a first electron doping area formation operation in which a third ion having third energy is doped in the direction perpendicular to the base substrate to form a first electron doping area, and a second electron doping area formation operation in which a fourth ion having fourth energy different from the third energy is doped in the direction perpendicular to the base substrate to form a second electron doping area.

The first ion and the second ion may include boron (B).

The third ion and the fourth ion may include arsenic (AS) or phosphorus (P).

In an embodiment of the present disclosure, the gate formation operation may include a masking operation in which upper surfaces of the first vertical semiconductor layer and the second vertical semiconductor layer are covered with a mask, a first insulating operation in which an insulating layer that covers side surfaces of the first hole doping area and the first electron doping area is formed, a gate electrode arrangement operation in which a gate electrode having a shape surrounding the first vertical semiconductor layer and the second vertical semiconductor layer is arranged on the insulating layer, and an etching operation in which an overlapping portion between the gate electrode and the second hole doping area or the second electron doping area is etched.

In an embodiment of the present disclosure, the connection metal formation operation may include a mask removal operation in which the mask that covers the upper surfaces of the first vertical semiconductor layer and the second vertical semiconductor layer is removed and a connection metal contact operation in which the connection metal in contact with the first hole doping area and the first electron doping area is formed.

### BRIEF DESCRIPTION OF THE FIGURES

The above and other objects, features and advantages of the present disclosure will be more apparent from the following detailed description taken in conjunction with the accompanying drawings:
FIG. 1 is a perspective view exemplarily illustrating a CMOS inverter according to an embodiment of the present disclosure;
FIG. 2A is a view exemplarily illustrating a cross section of the CMOS inverter along line I-I' of FIG. 1 according to the embodiment of the present disclosure;
FIG. 2B is a view exemplarily illustrating a cross section of the CMOS inverter along line II-II' of FIG. 1 according to the embodiment of the present disclosure;
FIG. 3 is a view exemplarily illustrating a circuit diagram of the CMOS inverter of FIG. 1 according to the embodiment of the present disclosure;
FIG. 4 is a view exemplarily illustrating a cut cross section of the CMOS inverter according to the embodiment of the present disclosure;
FIGS. 5A and 5B are views exemplarily illustrating a cut cross section of the CMOS inverter according to the embodiment of the present disclosure;
FIGS. 6A, 6B, and 6C are views exemplarily illustrating a cut cross section of the CMOS inverter according to the embodiment of the present disclosure;
FIGS. 7A, 7B, and 7C are views exemplarily illustrating a cut cross section of the CMOS inverter according to the embodiment of the present disclosure;
FIG. 8 is a view exemplarily illustrating a cut cross section of the CMOS inverter according to the embodiment of the present disclosure;
FIG. 9 is a flowchart exemplarily illustrating a method of manufacturing a CMOS inverter according to an embodiment of the present disclosure; and
FIG. 10 exemplarily illustrates a vertical semiconductor layer formation operation in the method of manufacturing a CMOS inverter according to the embodiment of the present disclosure.

### DETAILED DESCRIPTION

Embodiments of the present disclosure will be described in more detail below with reference to the accompanying drawings. In the drawings, a ratio and a dimension of components may be exaggerated for an effective description of the technical content.

The term "including" should be understood to specify the existence of features, numbers, steps, operations, components, parts, or combinations thereof described in the specification and not to exclude, in advance, the existence or addition of one or more other features, numbers, steps, operations, components, parts, or combinations thereof.

Further, when it is described that a first component is disposed "on" a second component, the term "on" means an upper side or a lower side of the corresponding component and does not necessarily mean an upper side in the direction of gravity.

Further, when it is described that a first component is "connected" or "coupled" to a second component, the first component may be directly connected or coupled to the second component as well as the first component may be indirectly connected or coupled to the second component through a third component.

Further, terms such as first and second may be used to describe a component, but these terms are merely intended to distinguish a first component from a second component and not to limit essence, a sequence, or an order of the first and second components.

Embodiments of the present disclosure will be described in more detail below with reference to the accompanying drawings. In the drawings, a ratio and a dimension of components may be exaggerated for an effective description of the technical content.

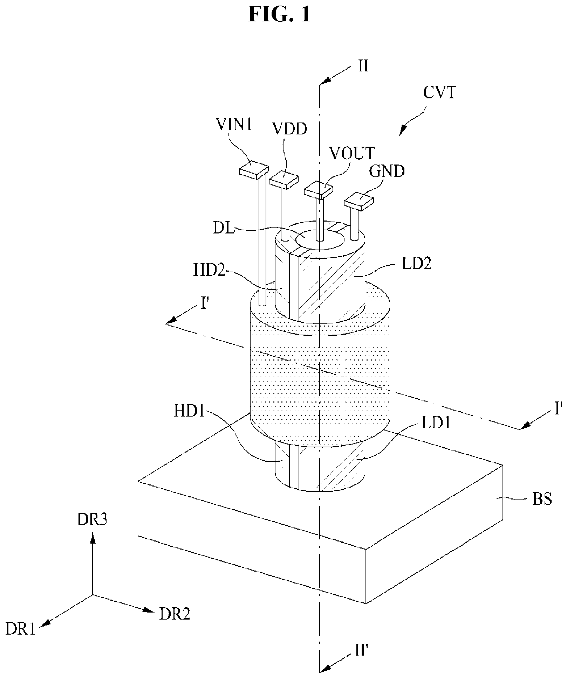

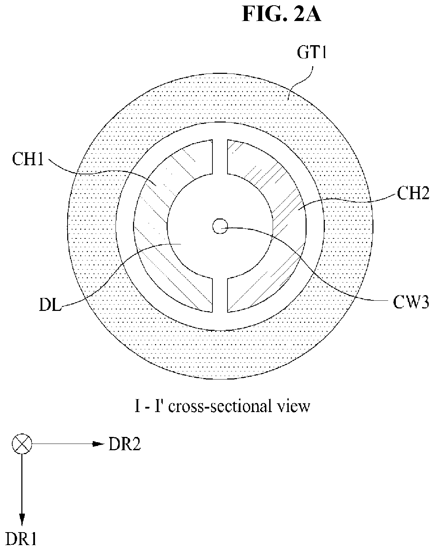

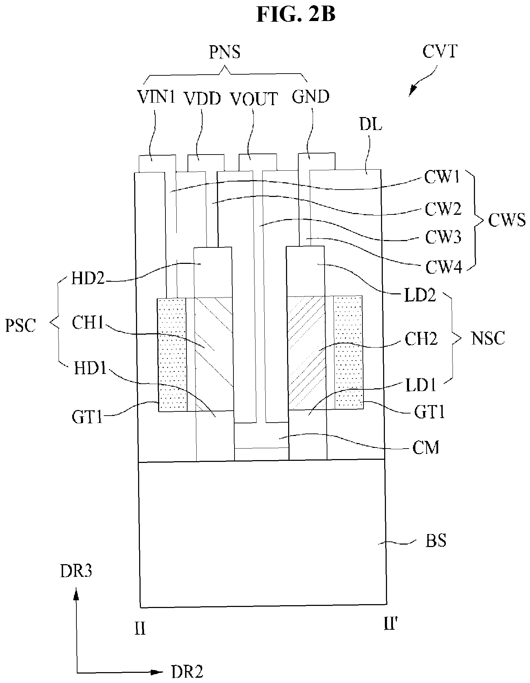

FIG. 1 is a perspective view exemplarily illustrating a CMOS inverter CVT according to an embodiment of the present disclosure. FIG. 2A is a view exemplarily illustrating a cross section of the CMOS inverter CVT along line I-I' of FIG. 1 according to the embodiment of the present disclosure. FIG. 2B is a view exemplarily illustrating a cross section of the CMOS inverter CVT along line II-II' of FIG. 1 according to the embodiment of the present disclosure.

Referring to FIGS. 1, 2A, and 2B, the CMOS inverter CVT according to an embodiment of the present disclosure may include a base substrate BS, a p-type semiconductor layer PSC, an n-type semiconductor layer NSC, and a first gate electrode GT1.

The base substrate BS is parallel to a plane defined by a first direction DR1 and a second direction DR2 intersecting the first direction DR1. The base substrate BS may include at least one of silicon, germanium, tensile silicon, tensile silicon germanium, or silicon carbide.

The p-type semiconductor layer PSC may be disposed on the base substrate BS. The p-type semiconductor layer PSC may include a first hole doping area HD1, a second hole doping area HD2, and a first channel area CH1. The p-type semiconductor layer PSC may be electrically connected to the first gate electrode GT1 to operate as a PMOS transistor.

The first hole doping area HD1 may be disposed adjacent to the base substrate BS. The first hole doping area HD1 may be defined as a drain area of the PMOS transistor.

The first channel area CH1 may be disposed adjacent to the first hole doping area HD1 in a third direction DR3 perpendicular to the first direction DR1 and the second direction DR2.

The second hole doping area HD2 may be disposed adjacent to the first channel area CH1 in the third direction DR3. The second hole doping area HD2 may be defined as a source area of the PMOS transistor.

The n-type semiconductor layer NSC may be disposed on the base substrate BS. The n-type semiconductor layer NSC may be spaced apart from the p-type semiconductor layer PSC. The n-type semiconductor layer NSC may include a first electron doping area LD1, a second electron doping area LD2, and a second channel area CH2. The n-type semiconductor layer NSC may be electrically connected to the first gate electrode GT1 to operate as a NMOS transistor.

The first electron doping area LD1 may be disposed adjacent to the base substrate BS. The first electron doping area LD1 may be defined as a drain area of the NMOS transistor.

The second channel area CH2 may be disposed adjacent to the first electron doping area LD1 in the third direction DR3.

The second electron doping area LD2 may be disposed adjacent to the second channel area CH2 in the third direction DR3. The second electron doping area LD2 may be defined as a source area of the NMOS transistor.

Each of the first channel area CH1 and the second channel area CH2 may include at least one of silicon, silicon germanium, tensile silicon, tensile silicon germanium, insulating layer buried silicon, silicon carbide, or a group 3-5 compound semiconductor.

The first gate electrode GT1 may be disposed on the base substrate BS. The first gate electrode GT1 may have a shape surrounding the first channel area CH1 and the second channel area CH2. The first gate electrode GT1 may be electrically connected to the first channel area CH1 and the second channel area CH2. The first gate electrode GT1 may include at least one of n-type polysilicon, p-type polysilicon, aluminum, molybdenum, chromium, palladium, platinum, nickel, titanium, tantalum, tungsten, silver, a titanium nitride, or a tantalum nitride.

Using the present disclosure, the p-type semiconductor layer PSC and the n-type semiconductor layer NSC may be vertically upright, thereby achieving high integration. The p-type semiconductor layer PSC and the n-type semiconductor layer NSC may share the first gate electrode GT1 without a gate electrode thereof. Accordingly, an area of the CMOS inverter may be reduced, and miniaturization thereof may be achieved.

The CMOS inverter CVT according to the embodiment of the present disclosure may further include a gate insulating film. The gate insulating film may be disposed on the base substrate BS. The gate insulating film may be disposed between the first gate electrode GT1 and the first channel area CH1. The gate insulating film may be formed after ions are doped into the p-type semiconductor layer PSC and the n-type semiconductor layer NSC. The gate insulating film may be disposed between the first gate electrode GT1 and the second channel area CH2. The gate insulating film may include at least one of an oxide film, a nitride film, an oxynitride film, an aluminum oxide, a hafnium oxide, a hafnium oxy nitride, a zinc oxide, a zirconium oxide, a polymer insulating film, a lanthanum-doped hafnia, or hafnium zirconium oxide or may be formed in a state of being filled with air.

The CMOS inverter CVT according to the embodiment of the present disclosure may further include a connection metal CM. The connection metal CM may be in contact with the first hole doping area HD1 and the first electron doping area LD1. The first hole doping area HD1 and the first electron doping area LD1 may be electrically connected to each other through the connection metal CM.

The CMOS inverter CVT according to the embodiment of the present disclosure may further include an insulating layer DL, a plurality of terminals PNS, and a plurality of connection wiring lines CWS.

The insulating layer DL may be disposed on the base substrate BS. The insulating layer DL may cover the p-type semiconductor layer PSC, the n-type semiconductor layer NSC, the connection metal CM, and the first gate electrode GT1.

The plurality of terminals PNS may be arranged on the insulating layer DL. The plurality of terminals PNS may include a first input terminal VIN1, a power terminal VDD, an output terminal VOUT, and a ground terminal GND.

The plurality of connection wiring lines CWS may be arranged on the base substrate BS. The plurality of connection wiring lines CWS may include a first connection wiring line CW1, a second connection wiring line CW2, a third connection wiring line CW3, and a fourth connection wiring line CW4.

The first connection wiring line CW1 may be in contact with the first input terminal VIN1 and the first gate electrode GT1. The first input terminal VIN1 and the first gate electrode GT1 may be electrically connected through the first connection wiring line CW1. The CMOS inverter CVT may receive an input signal through the first input terminal VIN1.

The second connection wiring line CW2 may be in contact with the power terminal VDD and the second hole doping area HD2. The power terminal VDD and the second hole doping area HD2 may be electrically connected to each other through the second connection wiring line CW2. The CMOS inverter CVT may receive power through the power terminal VDD.

The third connection wiring line CW3 may be in contact with the output terminal VOUT and the connection metal CM. The output terminal VOUT and the connection metal CM may be electrically connected to each other through the third connection wiring line CW3. The CMOS inverter CVT may output a signal through the output terminal VOUT.

The fourth connection wiring line CW4 may be in contact with the ground terminal GND and the second electron doping area LD2. The ground terminal GND and the second electron doping area LD2 may be electrically connected to each other through the fourth connection wiring line CW4. The CMOS inverter CVT may be grounded by receiving a reference potential of a circuit or 0V through the ground terminal GND.

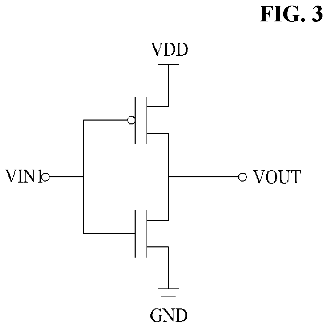

FIG. 3 is a view exemplarily illustrating a circuit diagram of the CMOS inverter CVT of FIG. 1 according to the embodiment of the present disclosure.

Referring to FIG. 3, the PMOS transistor to which the power terminal VDD is connected and the NMOS transistor to which the ground terminal GND is connected may be connected in series. A voltage is applied to a gate of each transistor from the first input terminal VIN1. As in the circuit illustrated in FIG. 3, the CMOS inverter CVT according to the present disclosure may be implemented and may operate as an inverter.

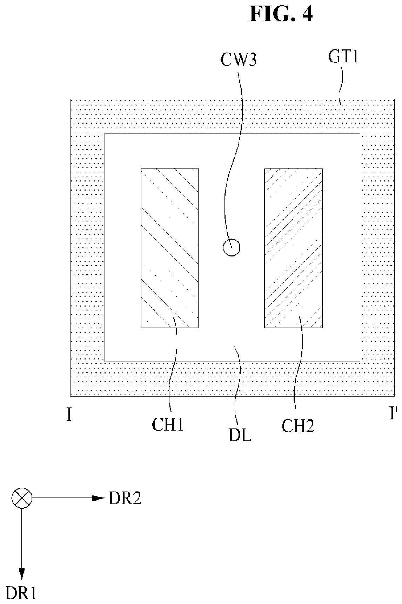

FIG. 4 is a view exemplarily illustrating a cut cross section of the CMOS inverter CVT according to the embodiment of the present disclosure.

Referring to FIGS. 2A and 4, the first gate electrode GT1 may have a shape surrounding the first channel area CH1 and the second channel area CH2. The first gate electrode GT1 may have a circular shape surrounding the first channel area CH1 and the second channel area CH2 as illustrated in FIG. 2A and may have a quadrangular shape surrounding the first channel area CH1 and the second channel area CH2 as illustrated in FIG. 4. The shape of the first gate electrode GT1 surrounding the first channel area CH1 and the second channel area CH2 is not limited to the circular shape or the quadrangular shape. The first gate electrode GT1 may have a circular shape, a semicircular shape, a square shape, a rectangular shape, or a polygonal shape.

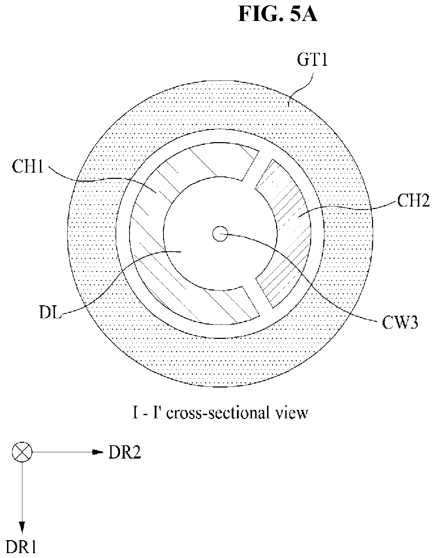

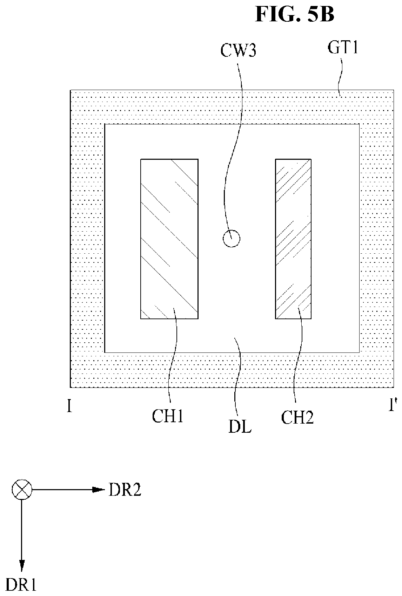

FIGS. 5A and 5B are views exemplarily illustrating a cut cross section of the CMOS inverter CVT according to the embodiment of the present disclosure.

Referring to FIGS. 5A and 5B, a cross-sectional area of the p-type semiconductor layer PSC may be greater than a cross-sectional area of the n-type semiconductor layer NSC. A main carrier of the p-type semiconductor layer PSC may be a hole, and a main carrier of the n-type semiconductor layer NSC may be an electron. Mobility of electrons is higher than that of holes. Accordingly, a cross-sectional area of the p-type semiconductor layer PSC may be greater than a cross-sectional area of the n-type semiconductor layer NSC, and driving currents of the p-type semiconductor layer PSC and the n-type semiconductor layer NSC may be the same. The driving currents of the p-type semiconductor layer PSC and the n-type semiconductor layer NSC may be the same, thereby improving power efficiency, improving performance, reducing heat generation, improving signal integrity, and achieving a uniform electric field distribution.

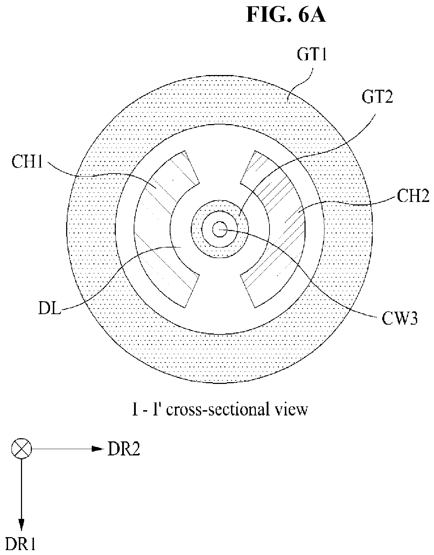

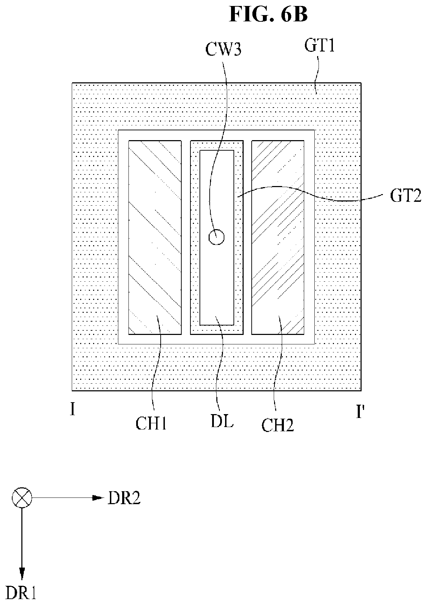

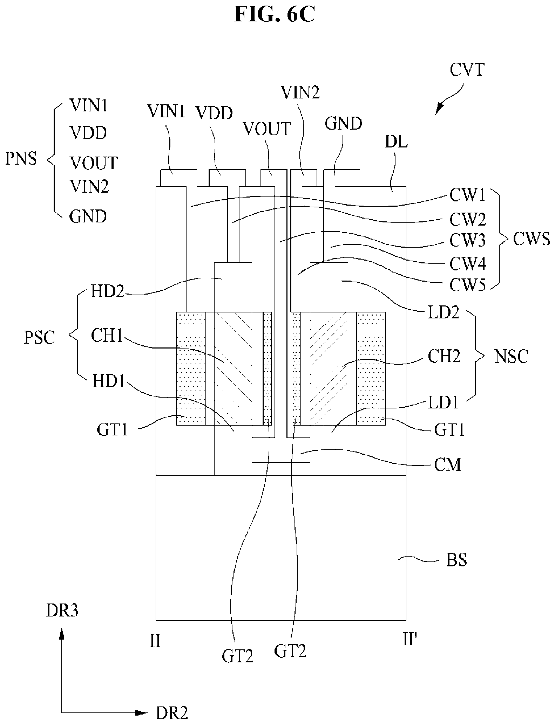

FIGS. 6A, 6B, and 6C are views exemplarily illustrating a cut cross section of the CMOS inverter CVT according to the embodiment of the present disclosure.

Referring to FIGS. 6A, 6B, and 6C, the CMOS inverter CVT may further include a second gate electrode GT2. The second gate electrode GT2 may be disposed on the base substrate BS. The second gate electrode GT2 may be spaced apart from the third connection wiring line CW3. The third connection wiring line CW3 may be disposed between the first channel area CH1 and the second channel area CH2. The second gate electrode GT2 may have a shape surrounding the third connection wiring line CW3.

The plurality of terminals PNS may further include a second input terminal VIN2. The plurality of connection wiring lines CWS may further include a fifth connection wiring line CWS. The fifth connection wiring line CWS may be in contact with the second input terminal VIN2 and the second gate electrode GT2. The second input terminal VIN2 and the second gate electrode GT2 may be electrically connected through the fifth connection wiring line CWS. The first gate electrode GT1 and the second gate electrode GT2 may be operated independently. The first gate electrode GT1 may be operated as a main gate. The second gate electrode GT2 may be operated as a sub-gate. The second gate electrode GT2, which serves as a sub-gate, may perform an additional function such as adjusting of a dynamic threshold voltage of the transistor.

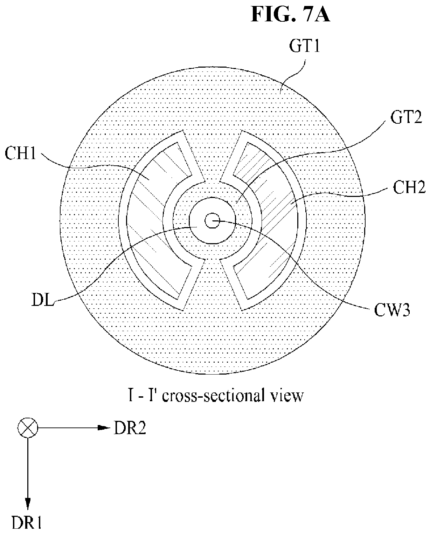

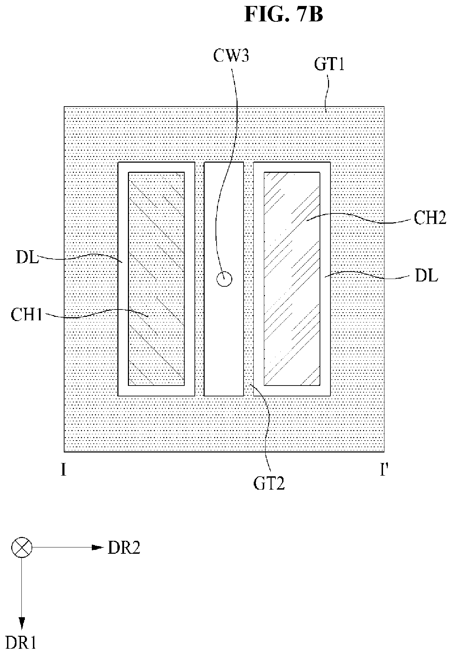

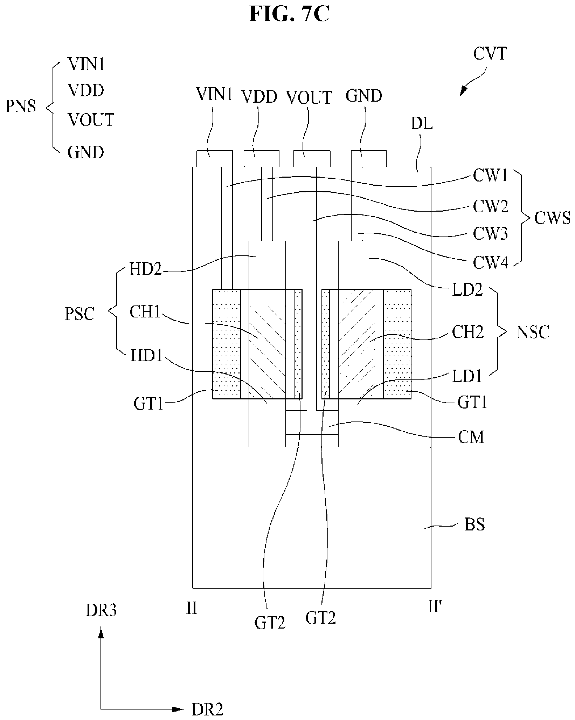

FIGS. 7A, 7B, and 7C are views exemplarily illustrating a cut cross section of the CMOS inverter according to the embodiment of the present disclosure.

Referring to FIGS. 7A, 7B, and 7C, the first gate electrode GT1 may be in contact with the second gate electrode GT2. The first gate electrode GT1 and the second gate electrode GT2 may be operated as a single gate. The first gate electrode GT1 and the second gate electrode GT2 may be operated as one gate completely surrounding the channel, thereby effectively suppressing a short channel effect.

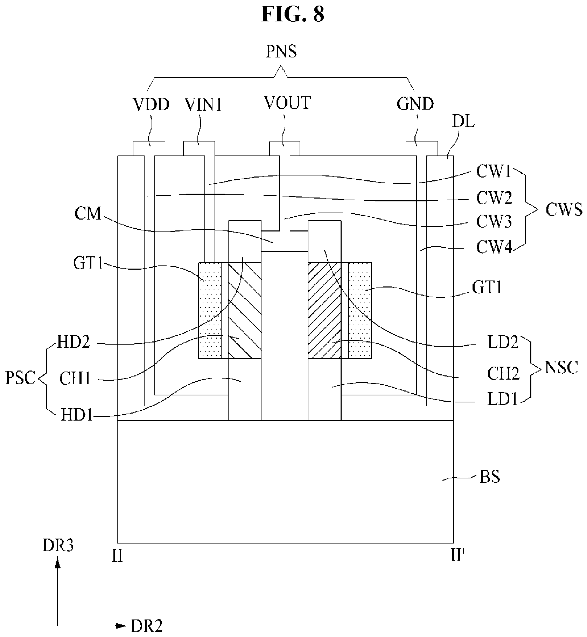

FIG. 8 is a view exemplarily illustrating a cut cross section of the CMOS inverter according to the embodiment of the present disclosure.

Referring to FIG. 8, the second connection wiring line CW2 may be in contact with the power terminal VDD and the first hole doping area HD1. The power terminal VDD and the first hole doping area HD1 may be electrically connected to each other through the second connection wiring line CW2. The first hole doping area HD1 may be defined as a source area of the PMOS transistor.

The connection metal CM may be in contact with the second hole doping area HD2 and the second electron doping area LD2. The second hole doping area HD2 and the second electron doping area LD2 may be electrically connected to each other through the connection metal CM. The second hole doping area HD2 may be defined as the drain area of the PMOS transistor. The second electron doping area LD2 may be defined as the drain area of the NMOS transistor.

The fourth connection wiring line CW4 may be in contact with the ground terminal GND and the first electron doping area LD1. The ground terminal GND and the first electron doping area LD1 may be electrically connected to each other through the fourth connection wiring line CW4. The first electron doping area LD1 may be defined as the source area of the NMOS transistor.

FIG. 8 illustrates that the second connection wiring line CW2 and the fourth connection wiring line CW4 are arranged outside the first gate electrode GT1 surrounding the first channel area CH1 and the second channel area CH2, but locations of the second connection wiring line CW2 and the fourth connection wiring line CW4 are not limited thereto. The second connection wiring line CW2 and the fourth connection wiring line CW4 may be arranged between the first gate electrode GT1 and the third connection wiring line CW3. The second connection wiring line CW2 and the fourth connection wiring line CW4 may be arranged not to overlap the first channel area CH1 and the second channel area CH2.

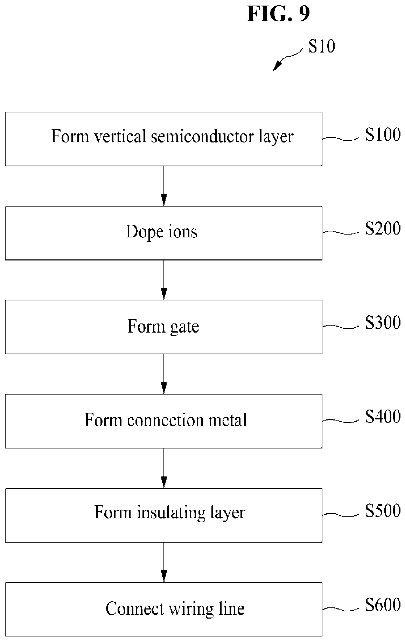

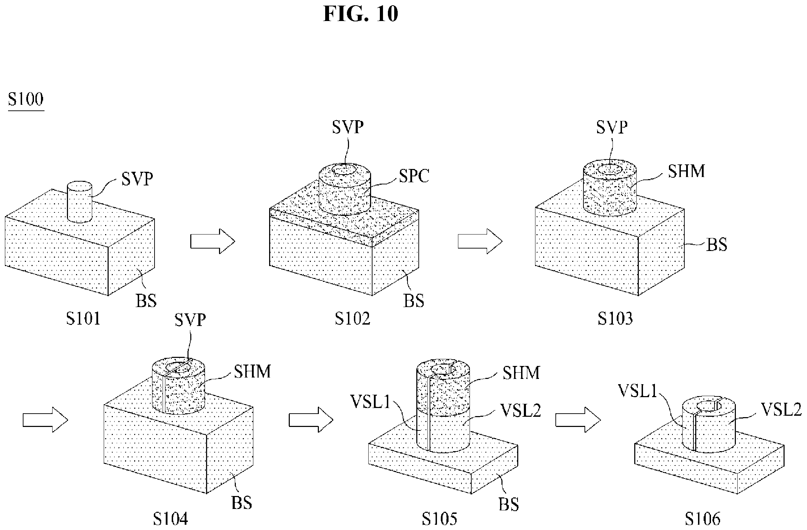

FIG. 9 is a flowchart exemplarily illustrating a method S10 of manufacturing a CMOS inverter according to an embodiment of the present disclosure. FIG. 10 exemplarily illustrates a vertical semiconductor layer formation operation S100 in the method S10 of manufacturing a CMOS inverter according to the embodiment of the present disclosure.

Referring to FIGS. 9 and 10, the method S10 of manufacturing the CMOS inverter CVT according to the embodiment of the present disclosure may include the vertical semiconductor layer formation operation S100 in which a first vertical semiconductor layer VSL1 and a second vertical semiconductor layer VSL2 are formed on the base substrate BS, an ion doping operation S200 in which ions are doped into the first vertical semiconductor layer VSL1 and the second vertical semiconductor layer VSL2, a gate formation operation S300 in which a gate electrode is formed on the base substrate BS, a connection metal formation operation S400 in which the connection metal CM in contact with the first vertical semiconductor layer VSL1 and the second vertical semiconductor layer VSL2 is formed on the base substrate BS, an insulating layer formation operation S500 in which the insulating layer DL covering the first vertical semiconductor layer VSL1, the second vertical semiconductor layer VSL2, the gate electrode, and the connection metal CM is formed, and a wiring line connection operation S600 in which the first vertical semiconductor layer VSL1, the second vertical semiconductor layer VSL2, the gate electrode, and the connection metal CM are connected to the plurality of terminals PNS arranged on the insulating layer DL.

The vertical semiconductor layer formation operation S100 may include a sacrificial vertical column formation operation S101 in which a sacrificial vertical column SVP is formed on the base substrate BS, a spacer formation operation S102 in which a spacer SPC covering a side surface of the sacrificial vertical column SVP and an upper surface of the base substrate BS is formed, a spacer hard mask formation operation S103 in which a portion of the spacer SPC is etched to form a spacer hard mask SHM surrounding the side surface of the sacrificial vertical column SVP, a cutting operation S104 in which the spacer hard mask SHM and the sacrificial vertical column SVP are cut in a direction perpendicular to the base substrate BS, a vertical layer formation operation S105 in which a portion of the base substrate BS and the sacrificial vertical column SVP are removed to form the first vertical semiconductor layer VSL1 and the second vertical semiconductor layer VSL2, and a spacer hard mask removal operation S106 in which the spacer hard mask SHM is removed.

In the embodiment of the present disclosure, the ion doping operation S200 may include a first hole doping area formation operation in which a first ion having first energy is doped in the direction perpendicular to the base substrate BS to form the first hole doping area HD1, a second hole doping area formation operation in which a second ion having second energy different from the first energy is doped in the direction perpendicular to the base substrate BS to form the second hole doping area HD2, a first electron doping area formation operation in which a third ion having third energy is doped in the direction perpendicular to the base substrate BS to form the first electron doping area LD1, and a second electron doping area formation operation in which a fourth ion having fourth energy different from the third energy is doped in the direction perpendicular to the base substrate BS to form the second electron doping area LD2.

In ion doping, at least one of diffusion, solid-phase diffusion, epitaxial growth, selective epitaxial growth, ion implantation, or subsequent heat treatment may be used. After the ion doping, the first vertical semiconductor layer VSL1 and the second vertical semiconductor layer VSL2 may be oxidized so that gate insulating films may be formed on outermost portions of the first vertical semiconductor layer VSL1 and the second vertical semiconductor layer VSL2. The gate insulating film may include at least one of an oxide film, a nitride film, an oxy nitride film, an aluminum oxide, a hafnium oxide, a hafnium oxy nitride, a zinc oxide, a zirconium oxide, a polymer insulating film, a lanthanum-doped hafnia, a hafnium zirconium oxide, or a state of being filled with air.

The first ion and the second ion may include boron (B). The first vertical semiconductor layer VSL1 may have a P-type semiconductor property.

The third ion and the fourth ion may include arsenic (AS) or phosphorus (P). The second vertical semiconductor layer VSL2 may have an N-type semiconductor property.

In the embodiment of the present disclosure, the gate formation operation S300 may include a masking operation in which upper surfaces of the first vertical semiconductor layer VSL1 and the second vertical semiconductor layer VSL2 are covered with a mask, a first insulating operation in which the insulating layer DL covering side surfaces of the first hole doping area HD1 and the first electron doping area LD1 is formed, a gate electrode arrangement operation in which a gate electrode having a shape surrounding the first vertical semiconductor layer VSL1 and the second vertical semiconductor layer VSL2 is arranged on the insulating layer DL, and an etching operation in which an overlapping portion between the gate electrode and the second hole doping area HD2 or the second electron doping area LD2 is etched.

The gate electrode may include at least one of n-type polysilicon, p-type polysilicon, aluminum, molybdenum, chromium, palladium, platinum, nickel, titanium, tantalum, tungsten, silver, a titanium nitride, or a tantalum nitride.

In the embodiment of the present disclosure, the connection metal formation operation S400 may include a masking removal operation in which a mask covering the upper surfaces of the first vertical semiconductor layer VSL1 and the second vertical semiconductor layer VSL2 is removed and a connection metal contact operation in which the connection metal CM in contact with the first hole doping area HD1 and the first electron doping area LD1 is formed.

Although the description has been made with reference to the embodiments, those skilled in the art may understand that the present disclosure may be variously modified and changed without departing from the spirit and scope of the present disclosure described in the appended claims. Further, it should be interpreted that an embodiment disclosed in the present disclosure is not intended to limit the technical spirit of the present disclosure and all technical spirits within the appended claims and equivalents thereto are included in the scope of the present disclosure.

## Claims

1. A complementary metal-oxide semiconductor (CMOS) inverter comprising:
a base substrate parallel to a plane defined by a first direction and a second direction intersecting the first direction;
a p-type semiconductor layer disposed on the base substrate and including a first hole doping area, a second hole doping area, and a first channel area;
an n-type semiconductor layer disposed on the base substrate, spaced apart from the p-type semiconductor layer, and including a first electron doping area, a second electron doping area, and a second channel area; and
a first gate electrode disposed on the base substrate and having a shape surrounding the first channel area and the second channel area and a gate insulating film,
wherein the first hole doping area is disposed adjacent to the base substrate,
wherein the first channel area is disposed adjacent to the first hole doping area in a third direction perpendicular to the first direction and the second direction,
wherein the second hole doping area is disposed adjacent to the first channel area in the third direction,
wherein the first electron doping area is disposed adjacent to the base substrate,
wherein the second channel area is disposed adjacent to the first electron doping area in the third direction, and
wherein the second electron doping area is disposed adjacent to the second channel area in the third direction.

2. The CMOS inverter of claim 1, further comprising:
a connection metal,
wherein the connection metal is in contact with the first hole doping area and the first electron doping area.

3. The CMOS inverter of claim 2, further comprising:
an insulating layer disposed on the base substrate and configured to cover the p-type semiconductor layer, the n-type semiconductor layer, the connection metal, and the first gate electrode;
a plurality of terminals arranged on the insulating layer; and
a plurality of connection wiring lines arranged on the base substrate,
wherein the plurality of terminals include a first input terminal, a power terminal, an output terminal, and a ground terminal,
wherein the plurality of connection wiring lines include a first connection wiring line, a second connection wiring line, a third connection wiring line, and a fourth connection wiring line,
wherein the first connection wiring line is in contact with the first input terminal and the first gate electrode,
wherein the second connection wiring line is in contact with the power terminal and the second hole doping area,
wherein the third connection wiring line is in contact with the output terminal and the connection metal, and
wherein the fourth connection wiring line is in contact with the ground terminal and the second electron doping area.

4. The CMOS inverter of claim 3, wherein a cross-section area of the p-type semiconductor layer is greater than a cross-sectional area of the n-type semiconductor layer.

5. The CMOS inverter of claim 3, further comprising:
a second gate electrode disposed on the base substrate and spaced apart from the third connection wiring line,
wherein the third connection wiring line is disposed between the first channel area and the second channel area, and
wherein the second gate electrode has a shape surrounding the third connection wiring line.

6. The CMOS inverter of claim 5, wherein the plurality of terminals further include a second input terminal disposed on the insulating layer,
wherein the plurality of connection wiring lines further include a fifth connection wiring line, and
wherein the fifth connection wiring line is in contact with the second input terminal and the second gate electrode.

7. The CMOS inverter of claim 5, wherein the first gate electrode is in contact with the second gate electrode to completely surround the first channel area and the second channel area.

8. The CMOS inverter of claim 1, further comprising:
a connection metal,
wherein the connection metal is in contact with the second hole doping area and the second electron doping area.

9. The CMOS inverter of claim 8, further comprising:
an insulating layer disposed on the base substrate and configured to cover the p-type semiconductor layer, the n-type semiconductor layer, the connection metal, and the first gate electrode;
a plurality of terminals arranged on the insulating layer; and
a plurality of connection wiring lines arranged on the base substrate,
wherein the plurality of terminals include a first input terminal, a power terminal, an output terminal, and a ground terminal,
wherein the plurality of connection wiring lines include a first connection wiring line, a second connection wiring line, a third connection wiring line, and a fourth connection wiring line,
wherein the first connection wiring line is in contact with the first input terminal and the first gate electrode,
wherein the second connection wiring line is in contact with the power terminal and the first hole doping area,
wherein the third connection wiring line is in contact with the output terminal and the connection metal,
wherein the fourth connection wiring line is in contact with the ground terminal and the first electron doping area.

10. A method of manufacturing a CMOS inverter, the method comprising:
a vertical semiconductor layer formation operation in which a first vertical semiconductor layer and a second vertical semiconductor layer are formed on a base substrate;
an ion doping operation in which ions are doped to the first vertical semiconductor layer and the second vertical semiconductor layer;
a gate formation operation in which a gate electrode is formed on the base substrate;
a connection metal formation operation in which a connection metal in contact with the first vertical semiconductor layer and the second vertical semiconductor layer is formed on the base substrate;
an insulating layer formation operation in which an insulating layer configured to cover the first vertical semiconductor layer, the second vertical semiconductor layer, the first gate electrode, and the connection metal is formed; and
a wiring line connection operation in which the first vertical semiconductor layer, the second vertical semiconductor layer, the first gate electrode, and the connection metal are connected to a plurality of terminals arranged on the insulating layer,
wherein the vertical semiconductor layer formation operation includes:
a sacrificial vertical column formation operation in which a sacrificial vertical column is formed on the base substrate;
a spacer formation operation in which a spacer configured to cover a side surface of the sacrificial vertical column and an upper surface of the base substrate is formed;
a spacer hard mask formation operation in which a portion of the spacer is etched to form a spacer hard mask surrounding the side surface of the sacrificial vertical column;
a cutting operation in which the spacer hard mask and the sacrificial vertical column are cut in a direction perpendicular to the base substrate;
a vertical layer formation operation in which a portion of the base substrate and the sacrificial vertical column are removed to form the first vertical semiconductor layer and the second vertical semiconductor layer; and
a spacer hard mask removal operation in which the spacer hard mask is removed.

11. The method of claim 10, wherein the ion doping operation includes:
a first hole doping area formation operation in which a first ion having first energy is doped in the direction perpendicular to the base substrate to form a first hole doping area;
a second hole doping area formation operation in which a second ion having second energy different from the first energy is doped in the direction perpendicular to the base substrate to form a second hole doping area;
a first electron doping area formation operation in which a third ion having third energy is doped in the direction perpendicular to the base substrate to form a first electron doping area; and
a second electron doping area formation operation in which a fourth ion having fourth energy different from the third energy is doped in the direction perpendicular to the base substrate to form a second electron doping area,
wherein the first ion and the second ion include boron (B), and
wherein the third ion and the fourth ion include arsenic (AS) or phosphorus (P).

12. The method of claim 11, wherein the gate formation operation includes:
a masking operation in which upper surfaces of the first vertical semiconductor layer and the second vertical semiconductor layer are covered with a mask;
a first insulating operation in which an insulating layer configured to cover side surfaces of the first hole doping area and the first electron doping area is formed;
a gate electrode arrangement operation in which a gate electrode having a shape surrounding the first vertical semiconductor layer and the second vertical semiconductor layer is arranged on the insulating layer; and
an etching operation in which an overlapping portion between the gate electrode and the second hole doping area or the second electron doping area is etched.

13. The method of claim 12, wherein the connection metal formation operation includes:
a mask removal operation in which the mask covering the upper surfaces of the first vertical semiconductor layer and the second vertical semiconductor layer is removed; and
a connection metal contact operation in which the connection metal in contact with the first hole doping area and the first electron doping area is formed.
